Europäisches Patentamt

European Patent Office

Office européen des brevets

(11) Publication number: **0 251 522**
**A2**

# EUROPEAN PATENT APPLICATION

(21) Application number: 87305058.7

(22) Date of filing: 08.06.87

(51) Int. Cl.4: **C30B 25/00** , **C30B 29/38**

(30) Priority: 24.06.86 JP 146012/86
18.07.86 JP 167847/86

(43) Date of publication of application:
**07.01.88 Bulletin 88/01**

(84) Designated Contracting States:
**DE FR GB**

(71) Applicant: **Ube Industries, Ltd.**
**12-32, Nishihonmachi 1-chome**
**Ube-shi, Yamaguchi-ken 755(JP)**

(72) Inventor: **Kohtoku, Yasuhiko Ube**
**Industries,Ltd.**
**Ube Kenkyusho 1978-5, Oaza Kogushi**
**Ube-shi Yamaguchi(JP)**
Inventor: **Masunaga, Katsuro Ube**
**Industries,Ltd.**
**Ube Kenkyusho 1978-5, Oaza Kogushi**
**Ube-shi Yamaguchi(JP)**

(74) Representative: **Fisher, Bernard et al**
**Raworth, Moss & Cook 36 Sydenham Road**
**Croydon Surrey CR0 2EF(GB)**

(54) **Process for production of beta-type silicon nitride.**

(57) A process for preparing a $\beta$-type silicon nitride whisker, which comprises calcining a powdery mixture of a starting material powder selected from amorphous silicon nitride and an $\alpha$-type silicon nitride and 0.0l to 20 parts by weight, in terms of the oxide, per l00 parts by weight of the starting material powder, of a rare earth element oxide powder or a powdery compound a rare earth element convertible to the oxide during calcination under a non-oxidative gas atmosphere. Thus, the desired $\beta$-type silicon nitride whisker can be produced with a good yield and efficiency.

*Fig. l*

## PROCESS FOR PRODUCTION OF BETA-TYPE SILICON NITRIDE

BACKGROUND OF THE INVENTION

I. Field of the Invention

The present invention relates to a process for preparing a $\beta$-type silicon nitride whisker useful as the base material for composite materials.

2. Description of the Related Art

A silicon nitride whisker is a single crystal grown in fine fibrous form without defect, has a very high tensile strength and modulus, and can be used as the base material for composite materials, particularly metal or ceramics composite materials subjected to high temperatures.

The Journal of the Ceramic Society of Japan ("Yogyo Kyokaishi") 91, 559 (1983) discloses a process for preparing a silicon nitride sintered product by mixing yttrium oxide powder and an amorphous silicon nitride powder and molding the formulated product, followed by calcination. This report discloses only a process for preparing a sintered product with the use of yttrium oxide as the sintering aid, and does not describe in any way a process for preparing a silicon nitride whisker.

Japanese Unexamined Patent Publication (Kokai) No. 59-147000 describes a process for producing a $\beta$-type silicon nitride whisker by carrying out a reaction while heating a mixture of silica, carbon, and cryolite in a mixed atmosphere of ammonia and nitrogen. In this process, cumbersome operations must be carried out for removal of the starting materials of silica and carbon remaining in the $\beta$-type silicon nitride whisker produced, and further, has a problem in that the yield of the whisker is low.

SUMMARY OF THE INVENTION

An object of the present invention is to provide a process for producing a $\beta$-type silicon nitride whisker with a good yield and efficiency.

Other objects and advantages of the present invention will be apparent from the following description.

In accordance with the present invention, there is provided a process for producing a $\beta$-type silicon nitride whisker comprising the step of calcining a powdery mixture of a starting material powder selected from amorphous silicon nitride and an $\alpha$-type silicon nitride and 0.0l to 20 parts by weight, in terms of oxide, per 100 parts by weight of the starting material powder, of a rare earth element oxide powder or a powdery compound of a rare earth element convertible to the oxide during calcination (hereinafter both are sometimes referred to as "rare earth element compound") under a nonoxidative gas atmosphere.

BRIEF DESCRIPTION OF THE DRAWING

The present invention will be better understood from the description set forth below with reference to the accompanying drawings, in which:

Figure I is a SEM photograph showing the particulate structure of a $\beta$-type silicon nitride whisker obtained in Example I;

Fig. 2 is an X-ray diffraction chart of the $\beta$-type silicon nitride whisker obtained in Example 3; and

Fig. 3 and Fig. 4 are an X-ray diffraction chart and a SEM photograph showing a particulate structure, respectively, of the $\beta$-type silicon nitride whisker obtained in Example 5.

DESCRIPTION OF THE PREFERRED EMBODIMENTS

The amorphous silicon nitride powder to be used in the present invention can be obtained by a method known per se, for example, by subjecting a reaction product obtained by the reaction of silicon tetrahalide and ammonia in a liquid phase or gas phase to a heat treatment. This is a so-called amorphous substance, which does not exhibit a clear diffraction phenomenon by ordinary X-ray diffraction measurement. Also, this amorphous silicon nitride may sometimes contain hydrogen atoms in addition to silicon atoms and nitrogen atoms.

The $\alpha$-type silicon nitride powder can be prepared by calcining amorphous silicon nitride powder obtained by the above-mentioned method, or other known methods such as, for example, a reductive nitrification of silica or a direct nitrification of silicon. The $\alpha$-type silicon nitride powder preferably has a specific surface area of 0.00I to 20 m²/g, particularly 2 to I3 m²/g.

Typical examples of the rare earth element are the lanthanum series elements such as yttrium, lanthanum, cerium, praseodium, neodium, samarium, europium, gadlinium, dysprosium, yttribium, and scandium.

As the compound capable of conversion to the oxide of a rare earth element during calcination, any compound which can be converted partially or wholly to the oxide during the growth of a β-type silicon nitride whisker may be used, and thereamong, hydroxides and carbonates of rare earth elements such as yttrium carbonate, yttrium hydroxide, lanthanum carbonate, and scandium hydroxide can be used.

The amount of the powdery compound of the rare earth element may be 0.01 to 20 parts by weight, preferably 0.5 to 10 parts by weight, in terms of oxide, per 100 parts by weight of the starting material powder selected from amorphous silicon nitride and α-type silicon nitride. If the amount of the rare earth element compound powder is less than the lower limit, the yield of whisker is low, and if the formulation amount is higher than the upper limit, fusion between the whiskers will occur.

The method for preparing the powdery mixture of the starting material powder and the rare earth element compound powder is not particularly limited, but a method known per se may be employed, such as the method in which both are dry blended or the method in which both are wet blended in an inert liquid followed by removal of the inert liquid. As the mixing device, a V-type mixer, ball mill or vibrating ball mill is preferably used. As an alternative method for preparation of the above mixture, it is possible to use the method in which the rare earth element compound powder is mixed and dispersed in a precursor of amorphous silicon nitride powder, such as silicon diimide or silicon tetramide, and the dispersion is subjected to a heat treatment. In the above preparation methods, when amorphous silicon nitride or a precursor thereof is used, since these are extremely sensitive to oxygen or water, they should be handled under a controlled inert atmosphere.

Typical examples of the non-oxidative gas used during calcination may include nitrogen, argon, ammonia or a gas mixture thereof. The calcination conditions are desirably such that the temperature of the powdery mixture is elevated from 1000°C to the maximum temperature over 0.1 to 40 hours, preferably 4 to 20 hours, on an average. The maximum temperature of calcination may be 1850°C or lower, preferably from 1500 to 1750°C. The furnace to be used during calcination of the powdery mixture is not particularly limited, but, for example, a batch system furnace using the high frequency induction heating or the resistance heating, a rotary furnace, or a pusher furnace may be exmployed.

According to the present invention, a β-type silicon nitride whisker having a high purity and not containing remnants of the starting materials used can be prepared with a good yield. The β-type silicon nitride whisker obtained in the present invention can be used for the reinforcement of metals or ceramics, particularly for the reinforcement of silicon nitride sintered products and Sialon sintered products.

## EXAMPLES

The present invention now will be further illustrated by, but is by no means limited to, the following Examples.

### Example 1

A 50 g amount of amorphous silicon nitride powder obtained by a heat decomposition of silicon diimide at 1200°C and 1.0 g of yttrium oxide having a 99.9% purity were mixed in a ball mill under a nitrogen gas atmosphere for 1 hour. The powdery mixture was placed in a crucible made of graphite having an inner diameter of 120 mm and an inner volume of 450 ml, set in a high frequency induction furnace and calcined by elevating the temperature under a nitrogen gas atmosphere from room temperature to 1200°C over 1 hour, from 1200 to 1400°C over 4 hours, from 1400 to 1650°C over 2.5 hours, and maintaining the temperature at 1650°C for 8 hours.

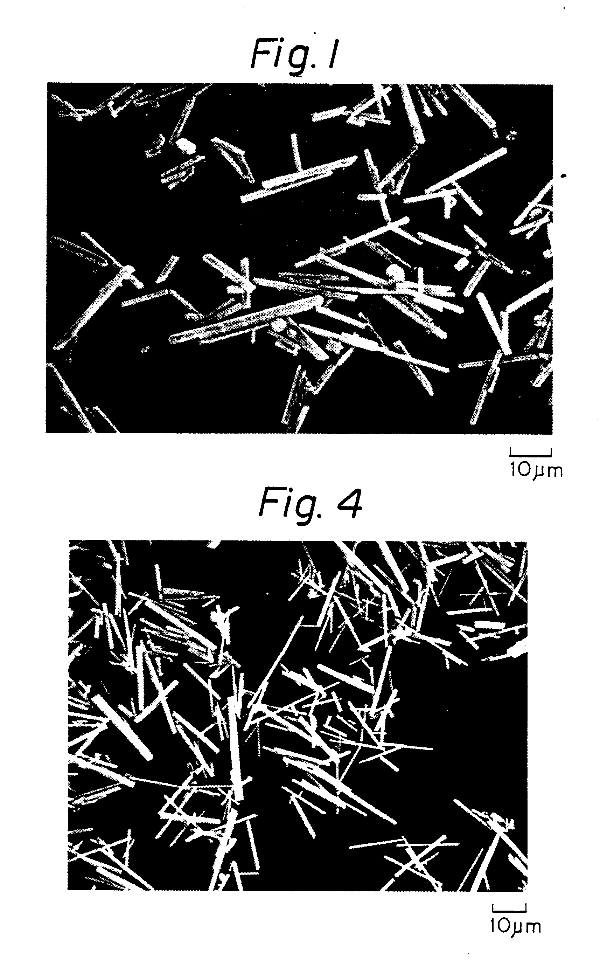

When the powder obtained was examined by X-ray diffraction, the crystal structure thereof was found to be β-type, and according to observation by a scanning electron microscope, it was recognized as a whisker having a length of 10 to 40 μm and a diameter of 0.5 to 1.5 μm, as shown in Fig. 1. The yield of the whisker based on amorphous silicon nitride (hereinafter referred to merely as yield) was 91%.

### Example 2

A 50 g amount of an α-type silicon nitride powder with a specific surface area of 5.3 m²/g and 1.5 g of yttrium oxide powder having a 99.9% purity were mixed in a vibrating ball mill for 2 hours. The powdery mixture was placed in a crucible made of graphite having an inner diameter of 120 mm and an inner volume of 450 ml, set in a high frequency induction furnace, and calcined by elevating the temperature under a nitrogen gas atmosphere from room temperature to 1200°C over 1 hour, from 1200 to 1750°C over 5.5 hours, and maintaining the temperature at 1750°C for 6 hours.

When the powder obtained was examined by X-ray diffraction, the crystal structure thereof was found to be β-type, and according to observation by a scanning electron microscope, was recognized as a whisker having a length of 25 to 30 μm and a diameter of 0.7 to 1.5 μm. The yield was 93%.

## Example 3

A 200 g amount of amorphous silicon nitride powder obtained by heat decomposition of silicon diimide at 1200°C and 10 g of yttrium oxide having a 99.9% purity were mixed in a vibrating ball mill under a nitrogen gas atmosphere for 1 hour. The powdery mixture was placed in a crucible made of graphite having an inner diameter of 290 mm and a height of 70 mm, set in a resistance heating furnace and calcined by elevating the temperature under a nitrogen gas atmosphere from room temperature to 1200°C over 1 hour, from 1200 to 1400°C over 4 hours, from 1400 to 1700°C over 3 hours, and maintaining the temperature at 1700°C for 7 hours.

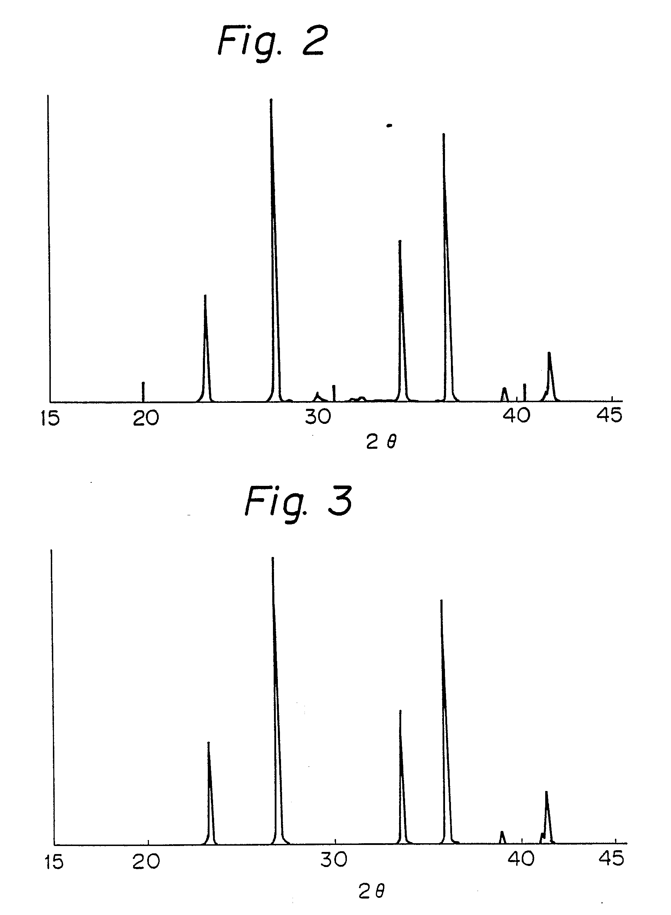

When the powder obtained was examined by X-ray diffraction, the crystal structure thereof was found to be β-type, as shown in Fig. 2, and according to observation by a scanning electron microscope, was recognized as a whisker having a length of 10 to 40 μm and a diameter of 0.5 to 1.5 μm.

## Example 4

A 150 g amount of amorphous silicon nitride powder and 9.3 g of yttrium hydroxide [Y(OH)$_3$] were mixed in a vibrating ball mill under a nitrogen gas atmosphere for 2 hours. The powdery mixture was placed in a crucible made of graphite having an inner diameter of 290 mm and a height of 70 mm, set in a resistance heating furnace, and calcined by elevating the temperature under a nitrogen gas atmosphere from room temperature to 1200°C over 1 hour, from 1200 to 1400°C over 3 hours, from 1400 to 1650°C over 2 hours, and maintaining the temperature at 1650°C for 12 hours.

When the powder obtained was examined by X-ray diffraction, the crystal structure thereof was found to be β-type, and according to observation by a scanning electron microscope, was recognized as a whisker having a length of 15 to 35 μm and a diameter of 0.7 to 1.5 μm. The yield was 89%.

## Example 5

A 50 g amount of an amorphous silicon nitride powder obtained by heat decomposition having a silicon diimide at 1200°C and 1.0 g of lanthanum oxide (La$_2$O$_3$) having a 99.9% purity were mixed in a ball mill under a nitrogen gas atmosphere for 1 hour. The powdery mixture was placed in a crucible made of graphite having an inner diameter of 120 mm and an inner volume of 450 ml, set in a high frequency induction furnace and calcined by elevating the temperature under a nitrogen gas atmosphere from room temperature to 1200°C over 1.5 hours, from 1200 to 1400°C over 4 hours, from 1400 to 1700°C over 3 hours, and maintaining the temperature at 1700°C for 7 hours.

When the powder obtained was examined by X-ray diffraction, the crystal structure thereof was found to be β-type, as shown in Fig. 3, and according to observation by a scanning electron microscope, was recognized as a whisker having a length of 10 to 30 μm and a diameter of 0.5 to 1.5 μm, as shown in Fig. 4. The yield was 91%.

## Example 6

A 50 g amount of an α-type silicon nitride powder with a specific surface area of 4.8 m$^2$/g and 2.6 g of lanthanum carbonate [La$_2$(CO$_3$)$_3$] powder having a 99.9% purity were mixed in a vibrating ball mill for 1 hour. The powdery mixture was placed in a crucible made of graphite having an inner diameter of 120 mm and an inner volume of 450 ml, set in a high frequency induction furnace and calcined by elevating the temperature under a nitrogen gas atmosphere from room temperature to 1200°C over 1 hour, from 1200 to 1750°C over 5.5 hours, and maintaining the temperature at 1750°C for 4 hours.

When the powder obtained was examined by X-ray diffraction, the crystal structure thereof was found to be β-type, and according to observation by a scanning electron microscope, was recognized as a whisker having a length of 25 to 30 μm and a diameter of 0.7 to 1.5 μm. The yield was 93%.

## Example 7

A 200 g amount of amorphous silicon nitride powder obtained by heat decomposition of silicon diimide at 1200°C and 8 g of cerium oxide (CeO₂) having a 99.9% purity were mixed in a vibrating ball mill under a nitrogen gas atmosphere for 1.5 hours. The powdery mixture was placed in a crucible made of graphite having an inner diameter of 290 mm and a height of 70 mm, set in a resistance heating furnace and calcined by elevating the temperature under a nitrogen gas atmosphere from room temperature to 1200°C over 2 hours, from 1200 to 1400°C over 4 hours, from 1400 to 1700°C over 3 hours, and maintaining the temperature at 1700°C for 8 hours.

When the powder obtained was examined by X-ray diffraction, the crystal structure thereof was found to be β-type, as shown in Fig. 2, and according to observation by a scanning electron microscope, was recognized as a whisker having a length of 10 to 40 μm and a diameter of 0.5 to 1.5 μm. The yield was 89%.

## Example 8

A 30 g amount of amorphous silicon nitride powder and 0.6 g of scandium oxide (SC₂O₃) powder were mixed in a ball mill under a nitrogen gas atmosphere for 1 hour. The powdery mixture was placed in a crucible made of graphite having an inner diameter of 290 mm and an inner volume of 450 ml, set in a high frequency induction furnace, and calcined by elevating the temperature under a nitrogen gas atmosphere from room temperature to 1200°C over 1.5 hours, from 1200 to 1450°C over 5 hours, from 1450 to 1650°C over 2 hours, and maintaining the temperature at 1650°C for 10 hours.

When the powder obtained was examined by X-ray diffraction, the crystal structure thereof was found to be β-type, and according to observation by a scanning electron microscope, was recognized as a whisker having a length of 15 to 30 μm and a diameter of 0.2 to 1.0 μm. The yield was 92%.

## Example 9

A 50 g amount of amorphous silicon nitride powder obtained by heat decomposition of silicon diimide at 1200°C and 2.5 g of samarium oxide (Sm₂O₃ powder were mixed in a sealed type V-type mixer under nitrogen gas atmosphere for 3 hours. The powder mixture was placed in a crucible made of graphite having an inner diameter of 290 mm and an inner volume of 450 ml, set in a high frequency induction furnace, and calcined by elevating the temperature under a nitrogen gas atmosphere from room temperature to 1200°C over 2 hours, from 1200 to 1400°C over 5 hours, from 1400 to 1600°C over 2 hours, and maintaining the temperature at 1600°C for 15 hours.

When the powder obtained was examined by X-ray diffraction, the crystal structure thereof was found to be β-type, and according to observation by a scanning electron microscope, 80% of the powder was recognized as a whisker having a length of 20 to 25 μm and a diameter of 1.0 to 1.2 μm, with the remainder being β-type particulate silicon nitride. The total yield of the whisker-shaped and particulate silicon nitride was 87%.

## Example 10

A 250 g amount of amorphous silicon nitride powder obtained by heat decomposition of silicon diimide at 1200°C and 6.3 g of dysprosium oxide (Dy₂O₃) powder having a 99.9% purity were mixed in a vibrating mill under a nitrogen gas atmosphere for 3 hours. The powdery mixture was placed in a crucible made of graphite having an inner diameter of 290 mm and a height of 70 mm, set in a resistance heating furnace, and calcined by elevating the temperature under a nitrogen gas atmosphere from room temperature to 1200°C over 2 hours, from 1200 to 1410°C over 3 hours, from 1410°C to 1720°C over 3 hours, and maintaining the temperature at 1720°C for 6 hours.

When the powder obtained was examined by X-ray diffraction, the crystal structure thereof was found to be β-type, and according to observation by a scanning electron microscope, was found to be a whisker having a length of 5 to 40 μm and a diameter of 0.2 to 1.2 μm. The yield was 89%.

**Claims**

1. A process for preparing a β-type silicon nitride whisker comprising the step of calcining a powdery mixture of a starting material powder selected from amorphous silicon nitride and an α-type silicon nitride and 0.01 to 20 parts by weight, in terms of the oxide per 100 parts by weight of the starting material powder, of a rare earth element oxide powder or a powdery compound of a rare earth element capable of conversion to the oxide during calcination under a non-oxidative gas atmosphere.

2. A process as claimed in claim 1, wherein said rare earth element is yttrium.

3. A process as claimed in claim I, wherein the specific surface area of the α-type silicon nitride powder is 0.00I to 20 m²/g.

4. A process as claimed in claim I, wherein the compound of rare earth element capable of conversion to the oxide during calcination is yttrium carbonate, yttrium hydroxide, lanthanum carbonate, or scandium hydroxide.

5. A process as claimed in claim I, wherein the calcination is carried out at a temperature of I000°C to I850°C for 0.I to 40 hours.

*Fig. I*

10μm

*Fig. 4*

10μm

# Fig. 2

$2\theta$

# Fig. 3

$2\theta$